# EUROPEAN PATENT SPECIFICATION

(11) **EP 4 008 807 B1**
(45) Date of publication and mention of the grant of the patent: **04.10.2023**
(21) Application number: 21179371.6
(22) Date of filing: 14.06.2021
(51) Int. Cl.: C25B 15/02, C25B 15/023

(54) **METHOD FOR MONITORING IMPEDANCE OF ELECTROLYZER, CONTROLLER AND POWER SUPPLY**
VERFAHREN ZUR ÜBERWACHUNG DER IMPEDANZ EINES ELEKTROLYSEURS, STEUERGERÄT UND STROMVERSORGUNG
PROCÉDÉ DE SURVEILLANCE D'IMPÉDANCE D'ÉLECTROLYSEUR, ORGANE DE COMMANDE ET ALIMENTATION ÉLECTRIQUE

(30) Priority: 04.12.2020 CN 202011407054
(43) Date of publication of application: 08.06.2022
(73) Proprietor: Sungrow Hydrogen Sci.&Tech. Co., Ltd., Hefei 230088, Anhui (CN)
(72) Inventor: Jiang, Cai, Hefei, Anhui, 230088 (CN); Liu, Yonghao, Hefei, Anhui, 230088 (CN); Fan, Zhixuan, Hefei, Anhui, 230088 (CN)
(74) Representative: Zacco Norway AS

(56) References cited:
- WO-A1-2021/162553
- US-A- 3 969 669
- US-A1- 2007 259 256

## Description

### FIELD

The present disclosure relates to the technical field of testing, and in particular to a method for monitoring impedance of an electrolyzer, a controller and a power supply.

### BACKGROUND

An electrolyzer is a core device for converting electric energy into hydrogen energy. Impedance of the electrolyzer can indicate service life of the electrolyzer to some extent. Generally, the impedance of the electrolyzer increases with the decrease (such as decrease of catalyst activity, coating shedding) of the service life of the electrolyzer. Therefore, it is important to monitor the impedance of the electrolyzer, for maintenance of the electrolyzer.

In the conventional technology, the impedance of the electrolyzer is monitored by embedding a wire in the electrolyzer in advance and using a voltage inspection device. Alternatively, a multimeter or other tool is used to directly measure a voltage of the electrolyzer, for evaluating an operation state or service life of the electrolyzer. The above methods both require an extra testing device or tool, having a high testing cost. WO2021/162553 provides an alternating current (AC) to direct current (DC) converting circuit for a turbine generator, which comprises an active AC/DC converter having an input for receiving alternating current electrical power from a turbine generator and an output for providing direct current electrical power to an electrolysis system for electrolysis of water. The AC/DC converter further comprises an oscillator for generating an alternating current auxiliary signal and a summation circuit for adding the alternating current signal to the output of the active AC/DC converter. By adding an AC component to the DC output of the active AC/DC converter, electrolysis cells in the electrolysis module connected to the AC/DC converting circuit can operate more efficiently. The amplitude of the alternating current auxiliary signal is preferably less than the output voltage of the active AC/DC converter. US3969669A provides a method of continuously determining the internal resistance of an electrolysis cell. In the method, a weak alternating current (if) of frequency (f) is superimposed upon the electrolysis current, the active part (rf) of the impedance which the cell offers to this alternating current is measured, followed by extrapolation to the zero frequency of the function giving the active part (rf) of the impedance as a function of the frequency (f), (rf) thus inclining towards the internal resistance of the cell. The invention is applicable to any electrolysis cell and more particularly to cells for the igneous electrolysis of alumina.

### SUMMARY

In view of this, a method for monitoring impedance of an electrolyzer, a controller and a power supply system are provided according to the appended set of claims.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.
Figure 1 is a schematic diagram of an electrolyzer impedance model according to an embodiment of the present disclosure;
Figure 2 is a schematic diagram of an impedance spectroscopy curve of an electrolyzer;
Figure 3 is a flow chart of a method for monitoring impedance of an electrolyzer according to an embodiment of the present disclosure;
Figure 4 is a schematic structural diagram of a power supply system of an electrolyzer according to an embodiment of the present disclosure;
Figure 5 is a schematic structural diagram of a power supply system of an electrolyzer according to another embodiment of the present disclosure;
Figure 6 is a schematic structural diagram of a power supply system of an electrolyzer according to the invention claimed of the present disclosure; and
Figure 7 is a schematic structural diagram of a power supply system of an electrolyzer according to the invention claimed of the present disclosure.

### DETAILED DESCRIPTION

In order to make objects, technical solutions and advantages of the present disclosure clearer, the technical solutions the embodiments of the present disclosure are further described clearly and completely with reference to the drawings in the embodiments of the present disclosure hereinafter. It is apparent that the described embodiments are only some embodiments of the present disclosure, rather than all embodiments.

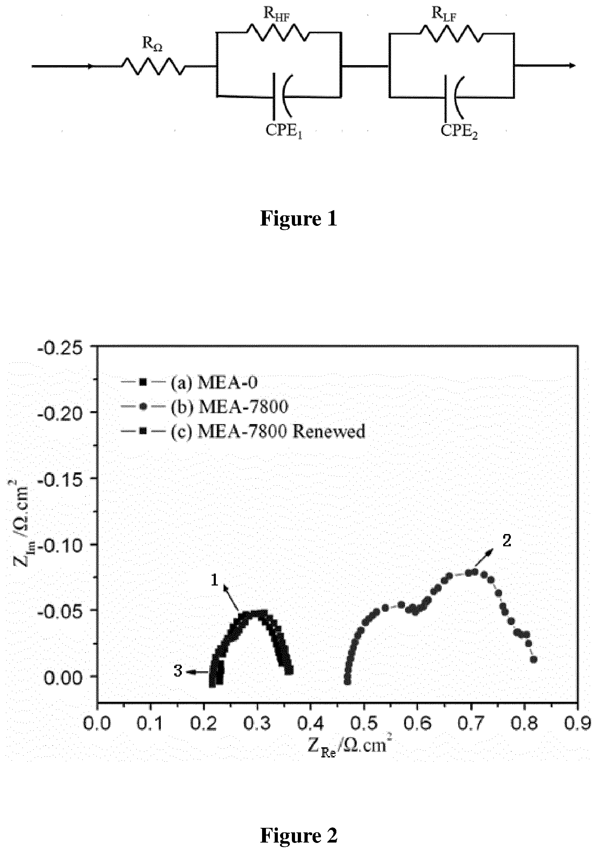

An equivalent model of the electrolyzer is shown in Figure 1. The impedance of the electrolyzer has a resistive-capacitive characteristic, mainly including a resistive component. Figure 2 is a schematic diagram of an impedance spectroscopy curve of the electrolyzer, in which a horizontal axis represents a real part of an impedance value and a vertical axis represents an imaginary part of the impedance value. A complete impedance curve can be acquired by acquiring impedance values corresponding to different frequency scanning points are acquired through an impedance scanning signal.

The operation state and service life of the electrolyzer can be determined from the monitored impedance of the electrolyzer. The impedance of the electrolyzer increases with the decrease of the service life of the electrolyzer. As shown in Figure 2, impedance of a newly produced electrolyzer is shown as the curve 1, then the impedance is changed to the curve 2 after the electrolyzer is used for a time period (for example, 7800 hours), and then the impedance is changed to the curve 3 after the electrolyzer is repaired and maintained.

By comparing the curve 1 and the curve 2, it can be seen that the overall impedance curve of the electrolyzer moves to the right of the curve 1 after the electrolyzer is used for a time period, indicating increased impedance. After the electrolyzer is repaired and maintained, the impedance curve substantially coincides with the curve 1 of the impedance of the original electrolyzer, indicating that the impedance returns to the original state.

In addition, a starting point on the left side of the curve indicates the resistive impedance of the electrolyzer. A diameter of a curve segment on the right side of the curve indicates the performance of an anode catalyst, and a diameter of a curve segment on the left side of the curve indicates the performance of a cathode catalyst. A small diameter indicates a good performance of the catalyst. Therefore, based on the above theory, the impedance, the service life and the maintenance situation of the electrolyzer can be acquired by analyzing the impedance curve.

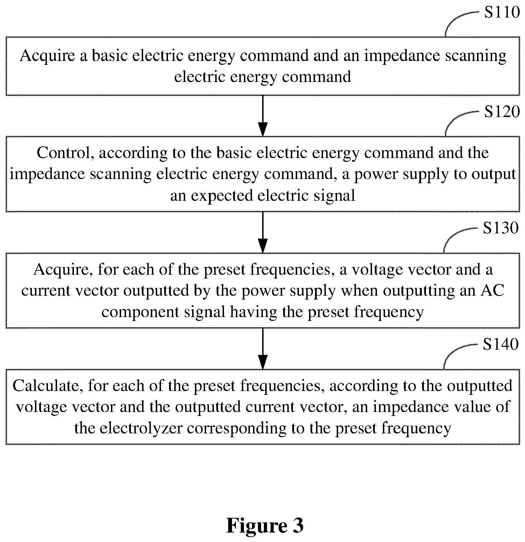

Reference is made to Figure 3, which is a flow chart of a method for monitoring impedance of an electrolyzer according to an embodiment of the present disclosure. The method is applied to a power supply system of an electrolyzer.

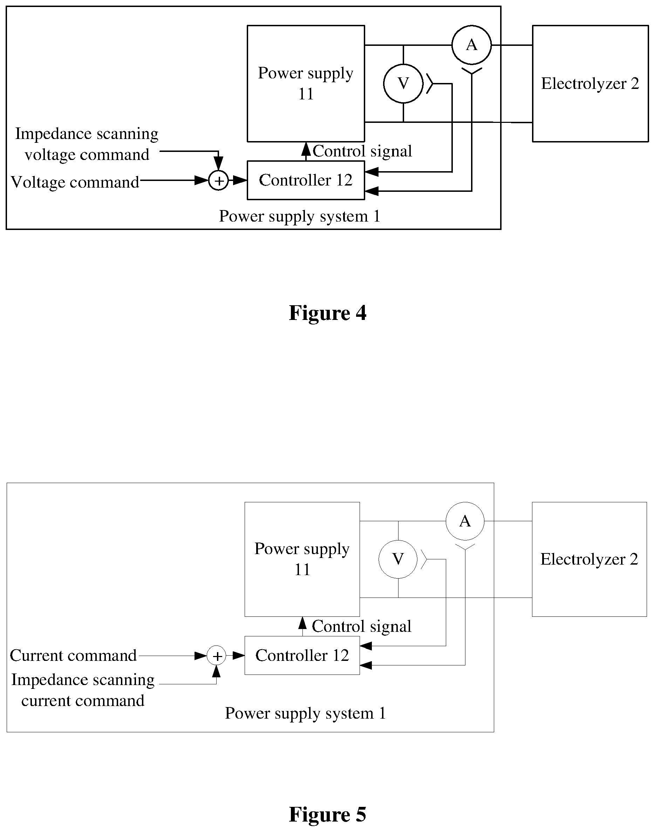

In an embodiment of the present disclosure, as shown in Figure 4, a power supply system 1 of an electrolyzer includes a power supply 11 and a controller 12.

The power supply 11 provides electric energy for an electrolyzer 2. The controller 12 controls an electric signal outputted by the power supply 11.

An output end of the power supply 11 is connected with a voltage sensor V and a current sensor A. The output end of the power supply 11 may be connected in parallel with the voltage sensor V to form a parallel branch and then the parallel branch is connected in series with the current sensor A. Alternatively, the output end of the power supply 11 may be connected in series with the current sensor A to form a series branch and then the series branch is connected in parallel with the voltage sensor V.

The method for monitoring impedance of an electrolyzer is described with reference to Figure 3 below. The method is applied to the controller 12. As shown in Figure 3, the method includes the following steps S110 to S140.

In step S110, a basic electric energy command and an impedance scanning electric energy command are acquired.

In an embodiment of the present disclosure, the basic electric energy command and the impedance scanning electric energy command may be generated by the controller 12, or may be received from outside.

In an embodiment, as shown in Figure 4, both the basic electric energy command and the impedance scanning electric energy command are voltage commands.

The basic electric energy command is used to control the power supply to output a DC voltage signal corresponding to the basic electric energy command. The impedance scanning electric energy command is used to control the power supply to output an AC voltage signal corresponding to the impedance scanning electric energy command.

The method of voltage control is commonly used in the initial commissioning of the electrolyzer to test whether a basic function of the electrolyzer is normal.

In another embodiment, as shown in Figure 5, both the basic electric energy command and the impedance scanning electric energy command are current commands.

The basic electric energy command is used to control the power supply to output a DC current signal corresponding to the basic electric energy command. The impedance scanning electric energy command is used to control the power supply to output an AC current signal corresponding to the impedance scanning electric energy command.

The method of current control is commonly used in the normal operation of the electrolyzer. The reason is that a functional relationship exists between a current and gas amount of hydrogen/oxygen produced by the electrolyzer, so that the amount of produced gas can be calculated according to the current value. In other words, the current command can be changed according to a gas production demand, to regulate the actual gas production.

In another embodiment of the present disclosure, the basic electric energy command and the impedance scanning electric energy command are used to control an output power of the power supply. Specifically, the output power is controlled by controlling an output current and/or an output voltage of the power supply.

In step S120, the power supply is controlled to output an expected electric signal according to the basic electric energy command and the impedance scanning electric energy command.

The expected electric signal includes a DC component signal and AC component signals. The DC component signal is used for normal operation of the electrolyzer. Frequencies of the AC component signals are preset frequencies in the impedance scanning electric energy command.

The preset frequencies may include multiple different frequencies.

In step S 130, for each of the preset frequencies, a voltage vector and a current vector outputted by the power supply when outputting the DC component signal and an AC component signal having the preset frequency are acquired.

The voltage sensor acquires, for each of the preset frequencies, a voltage vector outputted by the power supply 11 when outputting the AC component signal having the preset frequency and transmits the voltage vector to the controller 12. In addition, the current sensor acquires, for each of the preset frequencies, a current vector outputted by the power supply 11 when outputting the AC component signal having the preset frequency, and transmits the current sensor to the controller 12.

In step S 140, for at least one of the preset frequencies, an impedance value of the electrolyzer corresponding to the preset frequency is calculated according to the outputted voltage vector and the outputted current vector.

The voltage vector includes a voltage amplitude and a voltage phase. Similarly, the current vector includes a current amplitude and a current phase. The impedance value of the electrolyzer is calculated according to the voltage amplitude, the current amplitude and a difference between the voltage phase and the current phase.

In the normal operation, the electrolyzer can be equivalent to a model having resistive-capacitive impedance, mainly including resistive impedance. The operating power for the electrolyzer is DC power. Therefore, the electrolyzer under the normal operation condition is considered as a resistor. The resistance of the resistor is mainly related to a temperature of the electrolyzer and a current flowing through the electrolyzer. Heat capacity of water and heat capacity of a metal structure of the electrolyzer are two main parts of the heat capacity of the electrolyzer, which are both high so that the temperature changes slowly. Therefore, the temperature is approximately regarded as unchanged in seconds. Therefore, the impedance curve of the electrolyzer can be acquired by regulating the impedance scanning electric energy command, or regulating the impedance scanning electric energy command and the basic electric energy command.

In the method for monitoring impedance of an electrolyzer according to the embodiment, during the operation of the electrolyzer, an AC component signal is added to an electric signal inputted into the electrolyzer, to acquire an impedance value of the electrolyzer. Specifically, according to a basic electric energy command, a power supply connected with the electrolyzer is controlled to output a DC component signal for the normal operation of the electrolyzer, and according to an impedance scanning electric energy command, the power supply is controlled to output AC component signals used to monitor the impedance of the electrolyzer. A voltage vector and a current vector outputted by the power supply are acquired, and the impedance value of the electrolyzer is calculated according to the voltage vector and the current vector. With this method, the impedance scanning can be performed in a real-time manner during the normal operation of the electrolyzer, to calculate the impedance value of the electrolyzer, so as to evaluate the operation state and the service life of the electrolyzer. Moreover, the above process according to the present disclosure only requires hardware devices of the power supply without extra hardware devices, so that the hardware cost is reduced, and the safety of the process for monitoring the impedance of the electrolyzer is improved.

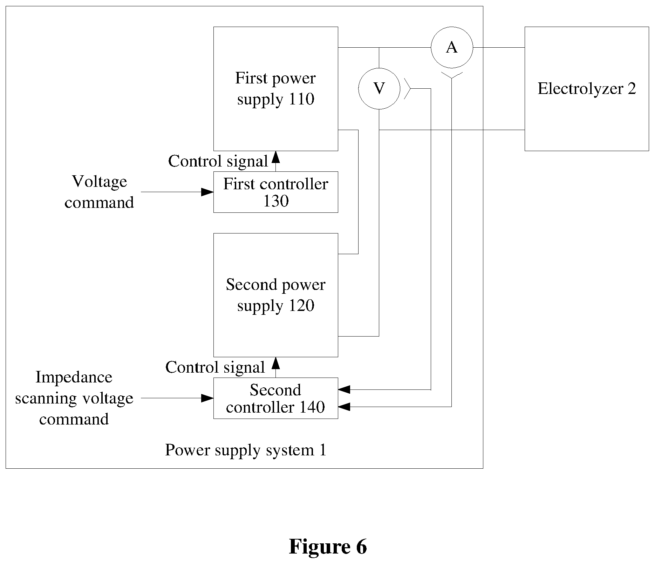

Reference is made to Figure 6, which is a schematic structural diagram of a power supply system of an electrolyzer according to another embodiment of the present disclosure. In the embodiment, a power supply system 1 includes a first power supply 110, a second power supply 120, a first controller 130 and a second controller 140.

An output end of the first power supply 110 is connected in series with an output end of the second power supply 120 to form a series branch, and then the series branch is connected with a power input end of an electrolyzer 2. In addition, an output end of the power supply system is connected in series with a current sensor A, and the output end of the power supply system is connected in parallel with a voltage sensor V.

The first controller 130 is configured to acquire a basic electric energy command, and control the first power supply 110 to output an expected DC electric signal according to the basic electric energy command.

The second controller 140 is configured to acquire an impedance scanning electric energy command, and control the second power supply 120 to output an expected AC electric signal according to the impedance scanning electric energy command.

In an embodiment of the present disclosure, the outputted voltage vector acquired by the voltage sensor and the outputted current vector acquired by the current sensor may be transmitted to the first controller 130, so that the first controller calculates an impedance value of the electrolyzer according to the outputted voltage vector and the outputted current vector.

In another embodiment, the second controller 140 receives the outputted voltage vector and the outputted current vector, and calculates the impedance value of the electrolyzer according to the outputted voltage vector and the outputted current vector.

In other embodiment of the present disclosure, the functions of the first controller 130 and the second controller 140 may be integrated into one controller, thereby reducing the hardware cost.

In the embodiment, both the basic electric energy command and the impedance scanning electric energy command are voltage commands, that is, the first controller and the second controller are configured to control voltage signals outputted by the power supply system.

According to the invention claimed the DC electric signal required for the normal operation of the electrolyzer is provided and controlled according to the actual gas production demand of the electrolyzer by using the first power supply and the first controller. In addition, the AC electric signals for impedance scanning are provided by using the second power supply and the second controller.

In other embodiment of the present disclosure, in order to share the second power supply and the second controller by multiple electrolyzers, the second power supply and the second controller are integrated into an impedance monitoring device independent of the first power supply and the first controller. The impedance monitoring device only provides the AC component signals for impedance scanning, which does not require a wire embedded in the electrolyzer in advance, or an extra device for measuring an electric signal.

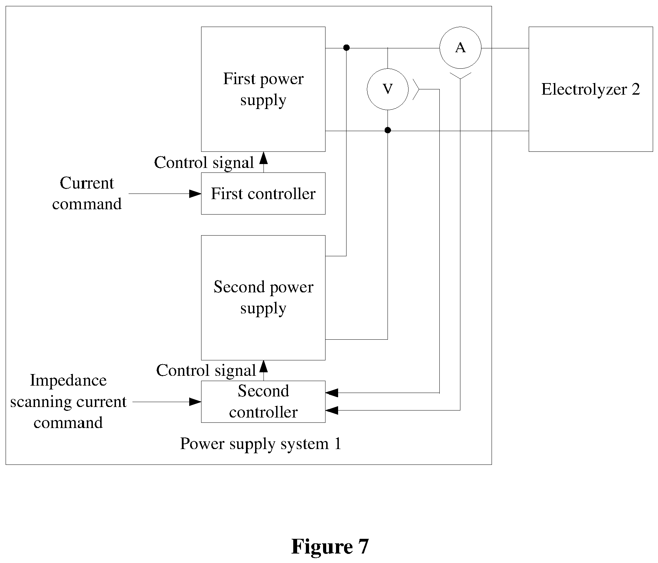

In another embodiment of the present disclosure, as shown in Figure 7, both the basic electric energy command and the impedance scanning electric energy command are current commands.

The first controller is configured to control a DC current signal outputted by the first power supply according to the basic electric energy command. The second controller is configured to control an AC current signal outputted by the second power supply according to the impedance scanning electric energy command.

Similar to the embodiment shown in Figure 6, the functions of the first controller and the second controller may be integrated into one controller, thereby reducing the hardware cost.

The second power supply and the second controller may also be integrated into an independent impedance monitoring device.

In the power supply system according to the embodiments shown in Figure 6 and Figure 7, the first power supply and the second power supply can operate independently of each other. Moreover, the second power supply and the second controller may be integrated into an independent impedance monitoring device that can be applied to multiple electrolyzers, which is convenient and universal.

In another aspect, a controller is further provided according to the present disclosure. The controller includes a processor and a memory. The memory stores a program executable by the processor. The processor is configured to execute the program stored in the memory, to perform the above method for monitoring impedance of an electrolyzer.

A storage medium for a computer device is further provided according to the present disclosure. The storage medium stores a program. The program, when being executed by the computer device, performs the above method for monitoring impedance of an electrolyzer.

It should be noted that technical features in different embodiments of the present disclosure may be replaced or combined with each other. Each of the embodiments emphasizes the differences from others, and the same or similar parts among the embodiments can be referred to each other. Since the device according to the embodiments is similar to the method therein, the description thereof is relatively simple, and for relevant matters references may be made to the description of the method.

The modules and sub-modules in the device and the terminal according to the embodiments of the present disclosure may be adjusted, divided or removed according to actual requirements.

The modules or sub-modules described as a separate component may be or may be not separated physically. The component displayed as a module or sub-module may be or may be not a physical module or a physical sub-module, that is, may be located at one place or may be distributed on multiple network modules or multiple network sub-modules. The object of the solution of the embodiment may be achieved by selecting a part or all of the modules or the sub-modules according to the actual requirements.

Furthermore, functional modules or sub-modules in different embodiments of the present disclosure may be integrated into one processing module, or may be separate physical modules or sub-modules respectively. Alternatively, two or more modules or sub-modules may be integrated into one module. The integrated module or sub-module may be implemented in a form of hardware, or may be implemented in a form of a software functional module or sub-module.

Finally, it should be further noted that the relationship terminologies such as first, second or the like are only used herein to distinguish one entity or operation from another, rather than to necessitate or imply that the actual relationship or order exists between the entities or operations. Furthermore, terms of "include", "comprise" or any other variants are intended to be non-exclusive. Therefore, a process, method, article or device including a series of elements includes not only the elements but also other elements that are not enumerated, or also includes the elements inherent for the process, method, article or device. Unless expressively limited otherwise, the statement "comprising (including) one..." does not exclude the case that other similar elements may exist in the process, method, article or device.

## Claims

1. A method for monitoring impedance of an electrolyzer, wherein the electrolyzer is connected to a power supply, and the method comprises:
acquiring (S110) a basic electric energy command and an impedance scanning electric energy command;
controlling (S120), according to the basic electric energy command and the impedance scanning electric energy command, the power supply to output an expected electric signal, wherein the expected electric signal comprises a direct current, DC, component signal and alternating current, AC, component signals, the DC component signal is used for normal operation of the electrolyzer, and frequencies of the AC component signals are preset frequencies in the impedance scanning electric energy command;
acquiring (S130), for each of the preset frequencies, a voltage vector and a current vector outputted by the power supply when outputting the DC component signal and an AC component signal having the preset frequency; and
calculating (S 140), for each of the preset frequencies, according to the outputted voltage vector and the outputted current vector, an impedance value of the electrolyzer corresponding to the preset frequency,
wherein the method is **characterized in that** the power supply comprises a first power supply and a second power supply, and the controlling (S120), according to the basic electric energy command and the impedance scanning electric energy command, the power supply to output an expected electric signal comprises:
controlling, according to the basic electric energy command, the first power supply to output the DC component signal in the expected electric signal; and
controlling, according to the impedance scanning electric energy command, the second power supply to sequentially output the AC component signals respectively having the preset frequencies.

2. The method according to claim 1, wherein
the basic electric energy command is used to control a DC voltage signal outputted by the first power supply, and the impedance scanning electric energy command is used to control an AC voltage signal outputted by the second power supply; or
the basic electric energy command is used to control a DC current signal outputted by the first power supply, and the impedance scanning electric energy command is used to control an AC current signal outputted by the second power supply.

3. The method according to claim 2, wherein
the basic electric energy command is used to control a DC power signal outputted by the first power supply, and the impedance scanning electric energy command is used to control an AC power signal outputted by the second power supply.

4. The method according to claim 1, wherein the acquiring, for each of the preset frequencies, a voltage vector and a current vector outputted by the power supply when outputting the DC component signal and an AC component signal having the preset frequency comprises:
receiving the voltage vector from a voltage sensor connected with an output end of the power supply; and
receiving the current vector from a current sensor connected with the output end of the power supply.

5. A controller for monitoring impedance of an electrolyzer, comprising:
a memory, storing a program; and
a processor, configured to execute the program to perform the method for monitoring impedance of an electrolyzer according to any one of claims 1 to 4.

6. A power supply system (1) for an electrolyzer (2), comprising:
a power supply (11), wherein an output end of the power supply (11) is connected with a voltage sensor and a current sensor, and the output end of the power supply (11) is connected with a power input end of the electrolyzer; and
a controller (12), configured to:
acquire a basic electric energy command and an impedance scanning electric energy command;
control, according to the basic electric energy command and the impedance scanning electric energy command, the power supply (11) to output an expected electric signal, wherein the expected electric signal comprises a direct current, DC, component signal and alternating current, AC, component signals, the DC component signal is used for normal operation of the electrolyzer, and frequencies of the AC component signals are preset frequencies in the impedance scanning electric energy command;
acquire, for each of the preset frequencies, a voltage vector and a current vector outputted by the power supply (11) when outputting the DC component signal and an AC component signal having the preset frequency; and
calculate, for each of the preset frequencies, according to the outputted voltage vector and the outputted current vector, an impedance value of the electrolyzer corresponding to the preset frequency,
wherein the power supply system (1) is **characterized in that**:
the power supply (11) comprises a first power supply (110) and a second power supply (120); and
the controller (12) is configured to:
control, according to the basic electric energy command, the first power supply (110) to output the DC component signal in the expected electric signal; and
control, according to the impedance scanning electric energy command, the second power supply (120) to sequentially output the AC component signals respectively having the preset frequencies.

7. The power supply system (1) according to claim 6, wherein the controller (12) comprises a first controller (130) and a second controller (140), wherein the first controller (130) is configured to control a DC voltage signal, a DC current signal or a DC power signal outputted by the first power supply (110), according to the basic electric energy command; and the second controller (140) is configured to control, an AC voltage signal, an AC current signal or an AC power signal outputted by the second power supply (120), according to the impedance scanning electric energy command.

8. The power supply system (1) according to claim 7, wherein the second power supply (120) and the second controller are integrated into an impedance monitoring device independent of the first power supply (110) and the first controller.

## Patentansprüche

1. Verfahren zum Überwachen der Impedanz eines Elektrolyseurs, wobei der Elektrolyseur mit einer Leistungsversorgung verbunden ist und das Verfahren Folgendes umfasst:
Erfassen (S110) eines Grundelektroenergiebefehls und eines Elektroenergiebefehls zur Impedanzabtastung;
Steuern (S120), gemäß dem Grundelektroenergiebefehl und dem Elektroenergiebefehl zur Impedanzabtastung, der Leistungsversorgung, um ein erwartetes elektrisches Signal auszugeben, wobei das erwartete elektrische Signal ein Gleichstrom-Komponentensignal, DC-Komponentensignal, und Wechselstrom-Komponentensignale, AC-Komponentensignale, umfasst, das DC-Komponentensignal für den normalen Betrieb des Elektrolyseurs verwendet wird und Frequenzen der AC-Komponentensignale voreingestellte Frequenzen im Elektroenergiebefehl zur Impedanzabtastung sind;
Erfassen (S130), für jede der voreingestellten Frequenzen, eines Spannungsvektors und eines Stromvektors, die von der Leistungsversorgung bei der Ausgabe des DC-Komponentensignals und eines AC-Komponentensignals mit der voreingestellten Frequenz ausgegeben werden; und
Berechnen (S140), für jede der voreingestellten Frequenzen, gemäß dem ausgegebenen Spannungsvektor und dem ausgegebenen Stromvektor, eines Impedanzwerts des Elektrolyseurs entsprechend der voreingestellten Frequenz,
wobei das Verfahren **dadurch gekennzeichnet ist, dass** die Leistungsversorgung eine erste Leistungsversorgung und eine zweite Leistungsversorgung umfasst, und das Steuern (S120), gemäß dem Grundelektroenergiebefehl und dem Elektroenergiebefehl zur Impedanzabtastung, der Leistungsversorgung, um ein erwartetes elektrisches Signals auszugeben, Folgendes umfasst:
Steuern, gemäß dem Grundelektroenergiebefehl, der ersten Leistungsversorgung, um das DC-Komponentensignal in dem erwarteten elektrischen Signal auszugeben; und
Steuern, gemäß dem Elektroenergiebefehl zur Impedanzabtastung, der zweiten Leistungsversorgung, um nacheinander die AC-Komponentensignale mit den jeweils voreingestellten Frequenzen auszugeben.

2. Verfahren nach Anspruch 1, wobei
der Grundelektroenergiebefehl verwendet wird, um ein DC-Spannungssignal zu steuern, das von der ersten Leistungsversorgung ausgegeben wird, und der Elektroenergiebefehl zur Impedanzabtastung verwendet wird, um ein AC-Spannungssignal zu steuern, das von der zweiten Leistungsversorgung ausgegeben wird; oder
der Grundelektroenergiebefehl verwendet wird, um ein DC-Stromsignal zu steuern, das von der ersten Leistungsversorgung ausgegeben wird, und der Elektroenergiebefehl zur Impedanzabtastung verwendet wird, um ein AC-Stromsignal zu steuern, das von der zweiten Leistungsversorgung ausgegeben wird.

3. Verfahren nach Anspruch 2, wobei
der Grundelektroenergiebefehl verwendet wird, um ein DC-Leistungssignal zu steuern, das von der ersten Leistungsversorgung ausgegeben wird, und der Elektroenergiebefehl zur Impedanzabtastung verwendet wird, um ein AC-Leistungssignal zu steuern, das von der zweiten Leistungsversorgung ausgegeben wird.

4. Verfahren nach Anspruch 1, wobei das Erfassen, für jede der voreingestellten Frequenzen, eines Spannungsvektors und eines Stromvektors, die von der Leistungsversorgung bei der Ausgabe des DC-Komponentensignals und eines AC-Komponentensignals mit der voreingestellten Frequenz ausgegeben werden, Folgendes umfasst:
Empfangen des Spannungsvektors von einem Spannungssensor, der mit einem Ausgangsende der Leistungsversorgung verbunden ist; und
Empfangen des Stromvektors von einem Stromsensor, der mit dem Ausgangsende der Leistungsversorgung verbunden ist.

5. Steuergerät zur Überwachung der Impedanz eines Elektrolyseurs, umfassend:
einen Speicher, auf dem ein Programm gespeichert ist; und
einen Prozessor, der dazu konfiguriert ist, das Programm auszuführen, um das Verfahren zum Überwachen der Impedanz eines Elektrolyseurs nach einem der Ansprüche 1 bis 4 durchzuführen.

6. Leistungsversorgungssystem (1) für einen Elektrolyseur (2), umfassend:
eine Leistungsversorgung (11), wobei ein Ausgangsende der Leistungsversorgung (11) mit einem Spannungssensor und einem Stromsensor verbunden ist und das Ausgangsende der Leistungsversorgung (11) mit einem Leistungseingangsende des Elektrolyseurs verbunden ist; und
ein Steuergerät (12), das zu Folgendem konfiguriert ist:
Erfassen eines Grundelektroenergiebefehls und eines Elektroenergiebefehls zur Impedanzabtastung;
Steuern, gemäß dem Grundelektroenergiebefehl und dem Elektroenergiebefehl zur Impedanzabtastung, der Leistungsversorgung (11), um ein erwartetes elektrisches Signal auszugeben, wobei das erwartete elektrische Signal ein Gleichstrom-Komponentensignal, DC-Komponentensignal, und Wechselstrom-Komponentensignale, AC-Komponentensignale, umfasst, das DC-Komponentensignal für den normalen Betrieb des Elektrolyseurs verwendet wird und Frequenzen der AC-Komponentensignale voreingestellte Frequenzen im Elektroenergiebefehl zur Impedanzabtastung sind;
Erfassen, für jede der voreingestellten Frequenzen, eines Spannungsvektors und eines Stromvektors, die von der Leistungsversorgung (11) bei der Ausgabe des DC-Komponentensignals und eines AC-Komponentensignals mit der voreingestellten Frequenz ausgegeben werden; und
Berechnen, für jede der voreingestellten Frequenzen, gemäß dem ausgegebenen Spannungsvektor und dem ausgegebenen Stromvektor, eines Impedanzwerts des Elektrolyseurs entsprechend der voreingestellten Frequenz,
wobei das Leistungsversorgungssystem (1) **dadurch gekennzeichnet ist, dass**:
die Leistungsversorgung (11) eine erste Leistungsversorgung (110) und eine zweite Leistungsversorgung (120) umfasst; und
das Steuergerät (12) zu Folgendem konfiguriert ist:
Steuern, gemäß dem Grundelektroenergiebefehl, der ersten Leistungsversorgung (110), um das DC-Komponentensignal in dem erwarteten elektrischen Signal auszugeben; und
Steuern, gemäß dem Elektroenergiebefehl zur Impedanzabtastung, der zweiten Leistungsversorgung (120), um nacheinander die AC-Komponentensignale mit den jeweils voreingestellten Frequenzen auszugeben.

7. Leistungsversorgungssystem (1) nach Anspruch 6, wobei das Steuergerät (12) ein erstes Steuergerät (130) und ein zweites Steuergerät (140) umfasst, wobei das erste Steuergerät (130) dazu konfiguriert ist, ein DC-Spannungssignal, ein DC-Stromsignal oder ein DC-Leistungssignal, die von der ersten Leistungsversorgung (110) ausgegeben werden, gemäß dem Grundelektroenergiebefehl zu steuern; und das zweite Steuergerät (140) dazu konfiguriert ist, ein AC-Spannungssignal, ein AC-Stromsignal oder ein AC-Leistungssignal, die von der zweiten Leistungsversorgung (120) ausgegeben werden, gemäß dem Elektroenergiebefehl zur Impedanzabtastung zu steuern.

8. Leistungsversorgungssystem (1) nach Anspruch 7, wobei die zweite Leistungsversorgung (120) und das zweite Steuergerät in eine Impedanzüberwachungsvorrichtung unabhängig von der ersten Leistungsversorgung (110) und dem ersten Steuergerät integriert sind.

## Revendications

1. Procédé de surveillance de l'impédance d'un électrolyseur, dans lequel l'électrolyseur est connecté à une alimentation électrique, et le procédé comprend :
l'acquisition (S110) d'une commande d'énergie électrique de base et d'une commande d'énergie électrique de balayage d'impédance ;
le contrôle (S120), selon la commande d'énergie électrique de base et la commande d'énergie électrique de balayage d'impédance, de l'alimentation électrique pour émettre un signal électrique attendu, dans lequel le signal électrique attendu comprend un signal de composant de courant continu, CC, et des signaux de composant de courant alternatif, CA, le signal de composant CC est utilisé pour le fonctionnement normal de l'électrolyseur, et les fréquences des signaux de composant CA sont des fréquences prédéterminées dans la commande d'énergie électrique à balayage d'impédance ;
l'acquisition (S130), pour chacune des fréquences prédéterminées, d'un vecteur de tension et d'un vecteur de courant émis par l'alimentation lors de l'émission du signal de composant CC et d'un signal de composant CA ayant la fréquence prédéfinie ; et
le calcul (S140), pour chacune des fréquences prédéterminées, selon le vecteur de tension émis et le vecteur de courant émis, d'une valeur d'impédance de l'électrolyseur correspondant à la fréquence prédéfinie,
dans lequel le procédé est **caractérisé en ce que** l'alimentation électrique comprend une première alimentation électrique et une seconde alimentation électrique, et le contrôle (S120), selon la commande d'énergie électrique de base et la commande d'énergie électrique de balayage d'impédance, de l'alimentation électrique pour émettre une valeur attendue de signal électrique comprend :
le contrôle, selon la commande d'énergie électrique de base, de la première alimentation électrique pour émettre le signal de composant CC dans le signal électrique attendu ; et
le contrôle, selon la commande d'énergie électrique de balayage d'impédance, de la seconde alimentation électrique pour émettre séquentiellement les signaux de composant CA ayant respectivement les fréquences prédéterminées.

2. Procédé selon la revendication 1, dans lequel
la commande d'énergie électrique de base est utilisée pour contrôler un signal de tension CC émis par la première alimentation, et la commande d'énergie électrique à balayage d'impédance est utilisée pour contrôler un signal de tension CA émis par la seconde alimentation ; ou
la commande d'énergie électrique de base est utilisée pour contrôler un signal de courant CC émis par la première alimentation, et la commande d'énergie électrique à balayage d'impédance est utilisée pour contrôler un signal de courant CA émis par la seconde alimentation.

3. Procédé selon la revendication 2, dans lequel
la commande d'énergie électrique de base est utilisée pour contrôler un signal d'alimentation CC émis par la première alimentation, et la commande d'énergie électrique à balayage d'impédance est utilisée pour contrôler un signal d'alimentation CA émis par la seconde alimentation.

4. Procédé selon la revendication 1, dans lequel l'acquisition, pour chacune des fréquences prédéterminées, d'un vecteur de tension et d'un vecteur de courant émis par l'alimentation lors de l'émission du signal de composant CC et d'un signal de composant CA ayant la fréquence prédéfinie comprend :
la réception du vecteur de tension d'un capteur de tension connecté à une extrémité d'émission de l'alimentation électrique ; et
la réception du vecteur de courant d'un capteur de courant connecté à l'extrémité d'émission de l'alimentation.

5. Dispositif de contrôle pour surveiller l'impédance d'un électrolyseur, comprenant :
une mémoire, stockant un programme ; et
un processeur, configuré pour exécuter le programme pour réaliser le procédé de surveillance de l'impédance d'un électrolyseur selon l'une quelconque des revendications 1 à 4.

6. Système d'alimentation (1) d'un électrolyseur (2), comprenant :
une alimentation électrique (11), dans lequel une extrémité d'émission de l'alimentation électrique (11) est connectée à un capteur de tension et à un capteur de courant, et l'extrémité d'émission de l'alimentation électrique (11) est connectée à une extrémité d'entrée de puissance de l'électrolyseur ; et
un dispositif de contrôle (12), configuré pour :
acquérir une commande d'énergie électrique de base et une commande d'énergie électrique à balayage d'impédance ;
contrôler, selon la commande d'énergie électrique de base et la commande d'énergie électrique de balayage d'impédance, l'alimentation électrique (11) pour émettre un signal électrique attendu, dans lequel le signal électrique attendu comprend un signal de composant de courant continu, CC, et des signaux de composant de courant alternatif, CA, le signal de composant CC est utilisé pour le fonctionnement normal de l'électrolyseur, et les fréquences des signaux de composant CA sont des fréquences prédéterminées dans la commande d'énergie électrique à balayage d'impédance ;
acquérir, pour chacune des fréquences prédéterminées, un vecteur de tension et un vecteur de courant émis par l'alimentation (11) lors de l'émission du signal de composant CC et d'un signal de composant CA ayant la fréquence prédéfinie ; et
calculer, pour chacune des fréquences prédéterminées, selon le vecteur de tension émis et le vecteur de courant émis, une valeur d'impédance de l'électrolyseur correspondant à la fréquence prédéfinie,
dans lequel le système d'alimentation électrique (1) est **caractérisé en ce que** :
l'alimentation (11) comprend une première alimentation (110) et une seconde alimentation (120) ; et
le dispositif de contrôle (12) est configuré pour :
contrôler, selon la commande d'énergie électrique de base, la première alimentation électrique (110) pour émettre le signal de composant CC dans le signal électrique attendu ; et
contrôler, selon la commande d'énergie électrique de balayage d'impédance, la seconde alimentation électrique (120) pour délivrer séquentiellement les signaux de composant CA ayant respectivement les fréquences prédéterminées.

7. Système d'alimentation électrique (1) selon la revendication 6, dans lequel le dispositif de contrôle (12) comprend un premier dispositif de contrôle (130) et un second dispositif de contrôle (140), dans lequel le premier dispositif de contrôle (130) est configuré pour contrôler un signal de tension CC, un signal de courant CC ou un signal de puissance CC émis par la première alimentation électrique (110), selon la commande d'énergie électrique de base ; et le second dispositif de contrôle (140) est configuré pour contrôler un signal de tension CA, un signal de courant CA ou un signal d'alimentation CA émis par la seconde alimentation (120), selon la commande d'énergie électrique de balayage d'impédance.

8. Système d'alimentation (1) selon la revendication 7, dans lequel la seconde alimentation (120) et le second dispositif de contrôle sont intégrés dans un dispositif de surveillance d'impédance indépendant de la première alimentation (110) et du premier dispositif de contrôle.
